(19) Europäisches Patentamt / European Patent Office / Office européen des brevets

(11) **EP 3 134 972 B1**

(12) **FASCICULE DE BREVET EUROPEEN**

(45) Date de publication et mention de la délivrance du brevet:
**14.03.2018 Bulletin 2018/11**

(21) Numéro de dépôt: **15717002.8**

(22) Date de dépôt: **17.04.2015**

(51) Int Cl.:
**H03K 17/041** (2006.01) **H03K 17/687** (2006.01)
**H03K 19/094** (2006.01)

(86) Numéro de dépôt international:
**PCT/EP2015/058410**

(87) Numéro de publication internationale:
**WO 2015/162063 (29.10.2015 Gazette 2015/43)**

(54) **CELLULE DE COMMUTATION DE PUISSANCE A TRANSISTORS A EFFET DE CHAMP DE TYPE NORMALEMENT CONDUCTEUR**

LEISTUNGSSCHALTZELLE MIT NORMALERWEISE LEITENDEN FELDEFFEKTTRANSISTOREN

POWER SWITCHING CELL WITH NORMALLY CONDUCTING FIELD-EFFECT TRANSISTORS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.04.2014 FR 1400948**

(43) Date de publication de la demande:
**01.03.2017 Bulletin 2017/09**

(73) Titulaires:
- **Thales**
  **92400 Courbevoie (FR)**
- **Commissariat à l'Énergie Atomique et aux Énergies Alternatives**
  **75015 Paris (FR)**
- **Université de Limoges**
  **87000 Limoges (FR)**
- **Centre National de la Recherche Scientifique**
  **75016 Paris (FR)**

(72) Inventeurs:
- **JARDEL, Olivier**
  **F-31500 Toulouse (FR)**
- **QUERE, Raymond**
  **F-19600 Saint Pantaleon de Larche (FR)**
- **PIOTROWICZ, Stéphane**
  **F-78114 Magny les Hameaux (FR)**
- **BOUYSSE, Philippe**
  **F-87260 Vicq-sur-Breuilh (FR)**
- **DELAGE, Sylvain**
  **F-91400 Orsay (FR)**
- **MARTIN, Audrey**
  **F-87570 Rilhac-Rancon (FR)**

(74) Mandataire: **Desvignes, Agnès et al**
**Marks & Clerk France**
**Immeuble Visium**
**22, avenue Aristide Briand**
**94117 Arcueil Cedex (FR)**

(56) Documents cités:
**WO-A1-2012/072503** **JP-A- S62 296 617**
**US-A- 5 278 422** **US-A- 5 514 996**

**Description**

**DOMAINE DE L'INVENTION**

L'invention concerne la commutation de puissance, et plus particulièrement la commutation de puissance pour des applications radiofréquences. Le domaine d'application de l'invention est notamment celui des systèmes de télécommunications sans fil ou des radars.

**ETAT DE L'ART**

**CONTEXTE**

Les signaux RF de télécommunications sont porteurs de plus en plus d'information, codée grâce à divers types de modulations (OFDM, 16-QAM...) qui induisent en particulier des variations importantes et rapides de leur enveloppe. Etant donnés les faibles rendements électriques des amplificateurs RF conventionnels pour amplifier ces signaux à modulations complexes, diverses architectures d'amplificateurs ont été proposées et développées, qui permettent d'obtenir de meilleurs rendements électriques d'amplification et de conserver une bonne linéarité.

Une technique d'amélioration du rendement électrique d'amplification consiste notamment à réaliser une gestion dynamique de la polarisation d'un amplificateur radiofréquence, en fonction des variations de l'enveloppe du signal à amplifier. Dans la littérature technique, on parle d'ailleurs de technique de suivi d'enveloppe (*"envelope tracking"*).

Les systèmes basés sur ce principe sont constitués entre autres de modulateurs de tensions, eux-mêmes constitués d'alimentations à découpage, dont la bande passante doit être au moins aussi large que celle de l'enveloppe des signaux RF à amplifier.

Un élément clé de ces alimentations à découpage est la cellule de commutation de puissance, qui permet de commuter à sa sortie un signal de puissance en fonction d'un signal de commande de faible puissance, appliqué à son entrée. Dans le domaine qui nous intéresse, la cellule de commutation de puissance doit satisfaire plus particulièrement à deux critères : rapidité de commutation et faible consommation électrique.

Pour répondre à ces besoins, des transistors dits « RF » (c'est-à-dire généralement prévus pour des applications à des fréquences RF ou micro-ondes) peuvent être utilisés. Les transistors à haute mobilité électronique (HEMT), notamment les transistors HEMTs en technologie GaN (nitrure de gallium), sont adaptés à ce type de réalisations en ce qu'ils sont capables de conduire des courants importants à des tensions élevées (leur conférant des bonnes dispositions pour être utilisés dans des circuits de puissance) tout en ayant des capacités intrinsèques parasites faibles par rapport aux autres technologies (leur permettant de grandes vitesses de commutation).

**PARTICULARITES ET DIFFICULTES DE REALISATION DE MODULATEURS RAPIDES**

Une des principales difficultés de réalisation de circuits de commutation rapide réside dans la réalisation de la commande des transistors de puissance dont le potentiel de source est flottant, c'est-à-dire non référencé à un potentiel fixe (généralement la masse) : elle varie entre un potentiel proche de zéro et un potentiel correspondant au niveau de la haute tension à commuter. Les techniques d'isolation de la commande de grille grâce à des optocoupleurs ou des transformateurs d'isolement ne semblent pas convenir pour ces applications à haute fréquences de commutation, à cause de leur relative lenteur. Des cellules de commutation à optocoupleurs et les problématiques associées sont par exemple décrites dans les documents US5,514,996 A et JPS62296617A. Par ailleurs, une particularité notable de nombreux transistors RF à effet de champ, et en particulier de la plupart des HEMTs GaN, est qu'ils ont un mode de fonctionnement dit « à déplétion ». C'est-à-dire que leur canal (de type N) est ouvert lorsque la tension appliquée entre leur grille et leur source est nulle. Dans ces conditions, si la tension entre drain et source n'est pas nulle, un courant non nul peut circuler entre drain et source. Pour arriver à bloquer un tel transistor, il faut dépléter son canal de charges libres, ce qui est obtenu en appliquant une tension grille-source négative, inférieure ou égale à la tension dite de pincement du transistor, notée Vp (cette tension Vp est donc négative). Dans la littérature technique anglo-saxonne, on parle de transistors « normally ON ». L'utilisation de transistors « normally-ON », si elle ne pose pas de difficulté particulière, n'est pas courante pour des applications de commutation et nécessite d'adapter les architectures connues à cette spécificité.

Le contrôle de polarisation de grille d'un transistor de puissance doit ainsi être conçu pour tout à la fois :

- s'adapter à la spécificité « normally-ON » de nombreux transistors RF à effet de champ ; et
- permettre une commutation rapide, sans risquer un claquage du transistor, c'est-à-dire avec une tension de grille qui évolue de façon bien maîtrisée par rapport à la tension de source flottante.

Par ailleurs les pertes électriques du commutateur doivent être les plus faibles possibles :

- en commutant (passage de l'état ON à l'état OFF et de l'état OFF à l'état ON) de façon la plus rapide possible, pour limiter les pertes de commutation, ce qui est rendu possible par le choix de la technologie de composants et par la réalisation d'un circuit de commande de grille adapté.
- en limitant les pertes de conduction : en choisissant des transistors ayant des résistances à l'état passant les plus faibles possible, et en limitant leurs fuites de courant de sortie à l'état bloqué, lorsque leur tension de sortie maximale, proche de la tension d'alimentation.

## DESCRIPTION D'UNE CELLULE DE L'ETAT DE L'ART

C'est dans ce contexte que la demande de brevet international publiée sous le numéro WO2012/072503 A1 a proposé une cellule de commutation de puissance à haute fréquence basée sur des transistors à effet de champ de type normalement conducteur, à commande non isolée, avec une approche innovante du contrôle de la polarisation de grille du transistor de puissance. Nous allons ici décrire brièvement sa structure de base et son fonctionnement, aux fins de la présentation de l'invention. Plus de détails seront trouvés dans le texte et les dessins de la demande précitée.

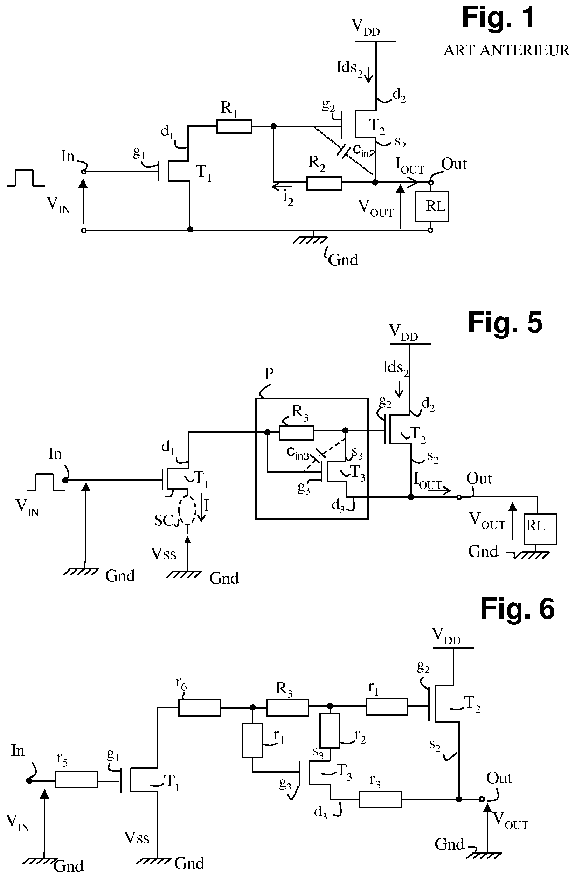

La structure de base de la cellule de la solution antérieure est schématiquement illustrée sur la figure 1. Elle comprend :

- un port d'entrée In qui reçoit un signal d'entrée $V_{IN}$ référencé par rapport à la masse générale de la cellule Gnd (0 volt) et qui commande la commutation de la cellule à l'état ON ou OFF ;
- un transistor d'entrée $T_1$, dont la grille $g_1$ est connectée au port d'entrée In de la cellule et dont la source est référencée à la masse électrique Gnd (0 volt) ;
- un transistor de puissance $T_2$, de type normalement conducteur ("Normally ON") dont le drain $d_2$ reçoit la tension d'alimentation positive $V_{DD}$ pour l'appliquer sur le port de sortie Out de la cellule, la source $s_2$ de ce transistor étant connectée au port de sortie Out ;
- une résistance $R_1$ qui est connectée en série entre le drain $d_1$ du transistor $T_1$ et la grille $g_2$ du transistor $T_2$ ; et
- une résistance $R_2$ dite d'auto-polarisation du transistor de puissance $T_2$ qui est connectée entre la grille $g_2$ et la source $s_2$ de ce transistor.

Le port de sortie Out est relié à un circuit aval, par exemple une charge purement résistive $R_L$, auquel la cellule fournit le signal de puissance de sortie défini par une tension de sortie $V_{OUT}$ et un courant de sortie $I_{OUT}$.

Dans cet exemple le transistor T1 est également de type normalement conducteur.

Cette cellule fonctionne comme suit: la source du transistor $T_1$ étant référencée à la masse générale de la cellule GND (0 volt), la tension grille-source du transistor $T_1$ est égale à la tension $V_{IN}$ appliquée en entrée de commande. Cette tension $V_{IN}$ varie typiquement entre une valeur haute, 0 volt ou +1 volt par exemple, pour commander le transistor $T_1$ à l'état passant ON et une valeur négative, inférieure ou égale à la tension de pincement du transistor ($V_{IN} \leq Vp$), pour commander le transistor $T_1$ à l'état bloqué OFF.

La commutation à haute fréquence du transistor de puissance à effet de champ $T_2$ d'un état ON à un état OFF, et réciproquement en fonction du signal d'entrée est assurée au moyen de la résistance d'auto-polarisation $R_2$. Cette résistance $R_2$ permet de contrôler la tension de polarisation de la grille $g_2$ du transistor de puissance :

- en fonction de l'état ON ou OFF du transistor $T_1$, la résistance $R_2$ étant connectée au drain $d_1$ du transistor $T_1$ par la résistance $R_1$ ; et
- à un niveau qui s'établit par rapport à la tension effective de la source flottante $s_2$ du transistor de puissance.

Plus précisément :

- lorsque la cellule est commandée à l'état ON, la tension $V_{IN}$ est inférieure ou égale à Vp, ce qui a pour conséquence de bloquer $T_1$, qui se comporte alors idéalement comme un circuit ouvert. Le courant dans $R_2$ est donc nul, entraînant une tension nulle aux bornes de $R_2$ et donc une tension $Vgs_2$ nulle elle aussi. Le transistor $T_2$ est alors à l'état passant ON, et la tension de sortie devient égale à $V_{DD}$.
- lorsque la cellule est commandée à l'état OFF, la tension $V_{IN}$ prend une valeur qui permet de rendre $T_1$ passant (par exemple $V_{IN}$ égale 0V, ou encore + 1volt). $T_1$ peut être alors considéré idéalement comme un interrupteur fermé. Un courant peut donc s'établir dans $R_2$, et ainsi la tension aux bornes de $R_2$ est non nulle. Dans ce cas de figure, le courant qui s'établit dans $R_2$ s'équilibre de façon à placer le transistor $T_2$ dans un état très proche du pincement ($Vgs_2$ très légèrement supérieure à Vp), par un effet de contre-réaction. En effet, si le courant $Ids_2$ est trop fort, le courant dans $R_2$ le sera aussi et la tension $Vds_2$ sera aussi trop forte, obligeant la fermeture de $T_2$ et

donc impliquant une diminution du courant $Ids_2$. Si le courant $Ids_2$ est trop faible, $Vds_2$ aura une trop faible valeur, ouvrant ainsi $T_2$ et augmentant son courant $Ids_2$. On a donc bien une auto-polarisation du transistor $T_2$ par la résistance d'auto-polarisation $R_2$.

Pour que la branche d'auto-polarisation fonctionne, le courant $I_2$ ne peut pas être nul, ce qui suppose que le transistor $T_2$ laisse toujours passer un peu de courant entre son drain et sa source. En d'autres termes, le transistor de puissance $T_2$ n'est pas amené complètement dans l'état bloqué ou OFF, mais plutôt à la limite du blocage. Du fait de ce courant drain-source non complètement nul, la tension $V_{out}$ en sortie Out ne sera pas tout à fait nulle non plus lorsque la cellule sera commandée à l'état OFF.

## AVANTAGES/INCONVENIENTS DE LA CELLULE DE L'ETAT DE L'ART

Cette cellule a différents avantages, comme expliqué en détails dans la demande précitée. Notamment, la vitesse de commutation est améliorée, car il suffit d'une variation très faible de la tension d'entrée, de l'ordre de quelques millivolts, au voisinage d'un seuil qui est fonction des deux valeurs des résistances $R_1$ et $R_2$, pour obtenir le basculement de la cellule. Par suite, le signal de commande appliqué en entrée ne nécessite pas une mise en forme soignée. La logique de commande en est simplifiée.

Mais cette cellule oblige à un compromis entre vitesse de commutation et pertes électriques. En effet, la résistance d'auto-polarisation $R_2$ doit répondre à deux contraintes antagonistes :

- on voudrait que cette résistance $R_2$ soit la plus élevée possible lorsque le transistor de puissance $T_2$ est non passant, à l'état OFF. En effet dans cet état OFF, la tension de source du transistor de puissance est proche de zéro, sans être nulle. Plus la résistance $R_2$ sera élevée, plus la tension de source sera tirée vers zéro : la consommation à l'état OFF du transistor de puissance sera d'autant plus faible.
- on voudrait que cette résistance $R_2$ soit la plus faible possible pour favoriser une commutation rapide du transistor de l'état OFF à l'état ON ; on cherche en effet à commuter à haute fréquence. Il s'agit ici de minimiser la constante de temps $\tau = C_{in2} * R_2$ associée à la charge de la capacité d'entrée $C_{in2}$ du transistor $T_2$, inhérente à sa technologie. La capacité d'entrée englobe la capacité grille-source du transistor et les capacités parasites ramenées sur la grille par effet Miller.

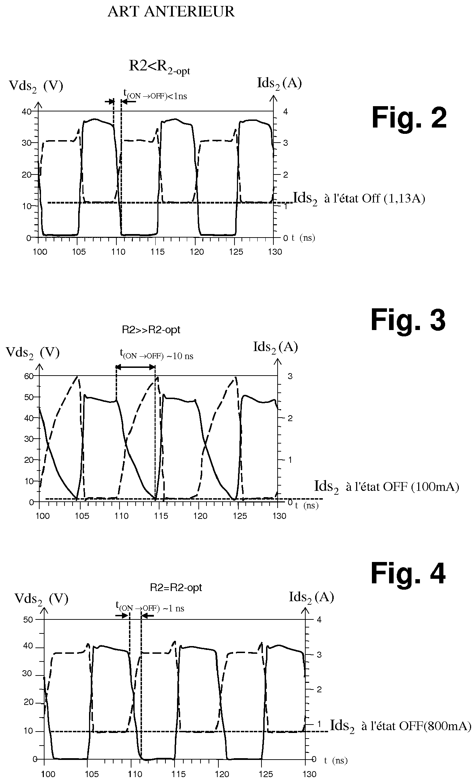

Les effets liés à ces deux contraintes apparaissent clairement sur les figures 2 à 4 qui montrent les courbes de tension ($V_{ds2}$) et courant ($I_{ds2}$) drain-source du transistor $T_2$ en fonction du temps, obtenues pour différentes valeurs de résistance d'auto-polarisation $R_2$. Les courbes de courant y sont représentées en traits pointillés et les courbes de tension en trait continu.

Ces courbes sont obtenues par simulation d'une cellule telle que représentée sur la figure 1, à partir de modèles de transistors HEMTs en technologie nitrure de gallium GaN.

Les conditions de simulation de cette cellule ont été les suivantes :

a). les transistors $T_1$ et $T_2$ sont des transistors HEMTs GaN RF ; leur fréquence de transition est supérieure à 10 Gigahertz ; leur tension de pincement Vp est de l'ordre de -3,5 volts.

b). le transistor de puissance $T_2$ a un développement total 8 fois supérieur à celui de $T_1$. Plus précisément, $T_2$ est formé par une barrette de huit transistors chacun ayant un développement total de grille de 6 x$400\mu$m ; $T_1$ est un transistor ayant un développement total de grille de 6 x$400\mu$m.

c). le signal logique $V_{IN}$ appliqué sur le port d'entrée In a un rapport cyclique de 50% et une fréquence de découpage de 100 MHz. Il varie entre 0 volt et -4,5 volts.

d). la charge simulée en sortie Out est purement résistive, de valeur 16 Ohms.

e). la haute tension $V_{DD}$ est égale à 50 volts.

En choisissant $R_2$=10 ohms, on obtient les courbes courant et tension illustrées sur la figure 2. Le temps de commutation $t_{(ON->OFF)}$ du transistor $T_2$ de l'état ON ($Vds_2$=0 volt) à l'état OFF ($Vds_2$ proche de $V_{DD}$) est rapide, inférieur à une nanoseconde. On voit que le transistor $T_2$ à l'état OFF n'est pas complètement bloqué et laisse passer un courant drain-source $Ids_2$ de l'ordre de 1,13 Ampères. Le niveau de tension drain-source $Vds_2$ à l'état OFF est inférieur à 40 volts. Ainsi, si le transistor $T_2$ commute vite de l'état ON à l'état OFF, les pertes électriques à l'état OFF sont en revanche élevées. Le rendement total calculé pour la cellule dans les conditions de la simulation est de 75%.

Le choix d'une valeur bien plus élevée de $R_2$, dans l'exemple illustré sur la figure 3, 100 Ohms favorise au contraire de faibles pertes électriques à l'état OFF, avec un courant drain source $Ids_2$ à l'état OFF très faible, de l'ordre de 100 milliampères. Le niveau de tension drain-source $Vds_2$ à l'état OFF est proche de $V_{DD}$. Cependant, le temps de commutation $t_{(ON->OFF)}$ est très dégradé et vaut environ 10 nanosecondes : la constante de temps liée à la capacité d'entrée du transistor de puissance est trop importante. Le rendement total calculé pour cette cellule dans les conditions de la simulation est de 70%.

La figure 4 montre ce que l'on obtient avec une valeur de résistance d'auto-polarisation $R_2$ optimisée pour cette cellule, pour essayer de satisfaire aux deux contraintes : temps de commutation rapide et pertes électriques à l'état OFF minimisées. Dans l'exemple, cette valeur optimisée de $R_2$ est égale à 18 ohms. Le temps de commutation est alors de l'ordre de 1 nanoseconde et le courant drain source $Ids_2$ à l'état OFF reste sous 1 ampère, 800 milliampères plus précisément. Le niveau de tension drain-source $Vds_2$ à l'état OFF est autour de 40 volts. Le rendement total de la cellule passe à 77% pour une puissance de sortie de 75 watts à la fréquence de découpage de 100 MHz.

Dans tous les cas, les pertes électriques induites par le courant drain-source à l'état OFF du transistor $T_2$ dégradent le rendement de la cellule qui est au mieux de 77% dans les conditions de simulation détaillées ci-dessus. Et ces pertes contribuent à altérer la durée de vie du transistor de puissance de ces cellules.

Ainsi, comme très bien mis en évidence sur ces figures, un problème de cette structure de cellule est le nécessaire compromis à faire entre vitesse de commutation et pertes électriques, par le choix de la valeur de la résistance d'auto-polarisation.

Les alimentations à découpage utilisées dans les modulateurs de polarisation dans des applications de suivi d'enveloppe doivent habituellement avoir des rendements supérieurs à 85% pour que la solution permette une amélioration globale du rendement du système, et ce à des fréquences de commutation de plusieurs MHz voire plusieurs dizaines de MHz. La cellule décrite précédemment se révèle mal adaptée pour ce type d'application, avec les technologies de transistors disponibles actuellement.

## RESUME DE L'INVENTION

L'invention a pour objet une cellule de commutation de puissance à commande non isolée, basée sur des transistors à effet de champ de type normalement conducteur, qui n'a pas les inconvénients précités.

Dans l'invention on a cherché à résoudre de manière plus performante, le contrôle de la polarisation de grille d'un transistor à effet de champ, de type normalement passant, utilisé dans un circuit de commutation de puissance et dont la source est flottante.

Les auteurs ont pu mettre en évidence qu'il est possible de s'affranchir pour bonne part du compromis entre le temps de commutation de l'état ON à l'état OFF et la valeur du courant résiduel à l'état OFF, permettant ainsi d'obtenir des rendements de fonctionnement plus importants de la cellule. Pour cela, la résistance d'auto polarisation $R_2$ est remplacée par un dispositif de commutation composé d'un transistor, dont le comportement s'apparente à une résistance variable.

Ce transistor d'auto-polarisation, de type normalement conducteur a l'avantage d'être commandé par le même transistor que le transistor de puissance $T_2$, permettant de conserver une simplicité de commande de la cellule.

De manière simplifiée, à l'état OFF du transistor de puissance, le transistor d'auto-polarisation selon l'invention est à l'état OFF et équivaut à une résistance de valeur élevée, favorable à une réduction des pertes électriques de la cellule à l'état OFF ; pendant la commutation du transistor de puissance, le transistor d'auto-polarisation selon l'invention passe rapidement à l'état ON et équivaut à une résistance de valeur très faible, favorable à une commutation très rapide du transistor de puissance.

Ce transistor d'auto-polarisation est également à source flottante. Il est avantageusement et efficacement commandé par une résistance d'auto-polarisation connectée entre sa source et sa grille, tel qu'enseigné par la cellule de l'art antérieur, à la différence que ce transistor n'est pas le transistor de puissance lui même, mais est un transistor d'auto-polarisation qui sert à contrôler la polarisation de grille du transistor de puissance.

La modification du circuit réalisée en remplaçant une résistance de valeur figée par un transistor auto-polarisé permet d'optimiser son fonctionnement en éliminant le compromis à faire sur la valeur de cette résistance : élevée pour réduire les pertes à l'état OFF, faible pour réduire les pertes en commutation.

Lorsque le circuit est bien réglé, avec un choix judicieux de ses composants et de leurs valeurs, le transistor se comporte comme une résistance variable dont la valeur est faible pendant la commutation du transistor principal, et élevée à l'état OFF. Les pertes électriques peuvent encore être réduites en choisissant de référencer la source du transistor d'entrée à un potentiel de référence négatif.

L'invention concerne donc une cellule de commutation de puissance comprenant,

- un port d'entrée apte à recevoir un signal de commande de commutation qui est référencé à une masse générale de la cellule, constituant une commande non-isolée de la cellule,
- un transistor de puissance à effet de champ, de type normalement conducteur, dont le drain est apte à recevoir une tension d'alimentation positive, définie par rapport à une masse à potentiel de référence nul, pour l'appliquer sur un port de sortie, la source du transistor de puissance étant connectée au port de sortie,
- un circuit d'auto-polarisation de la grille du transistor de puissance,

- un commutateur de courant connecté électriquement entre le circuit d'auto-polarisation et un potentiel de référence négatif ou nul dont une entrée de commande du commutateur est connectée au port d'entrée, et configuré pour que, sur activation par ledit signal de commande de commutation, il relie électriquement le potentiel de référence négatif ou nul au circuit d'auto-polarisation,

le circuit d'auto-polarisation comprend

- un transistor à effet de champ, de type normalement conducteur, dont le drain est connecté à la source du transistor de puissance et dont la source est connectée à la grille du transistor de puissance ;
- une résistance d'auto-polarisation de la grille du transistor du circuit d'auto-polarisation, qui est connectée entre la grille et la source dudit transistor d'auto-polarisation ; et en série entre le commutateur de courant et la source dudit transistor d'auto-polarisation.

La cellule peut comprendre une source de courant réglable connectée en série entre le commutateur de courant et la référence de tension négative ou nulle.

Selon un aspect de l'invention, le commutateur de courant est un transistor à effet de champ, notamment un transistor à effet de champ de type normalement conducteur.

La commutation de courant commandée par l'activation du commutateur de courant par le signal logique d'entrée, provoque la commutation à l'état OFF, dans un état à la limite du blocage, du transistor d'auto-polarisation et du transistor de puissance ; la désactivation du commutateur de courant provoque la commutation à l'état ON, conducteur, du transistor d'auto-polarisation et du transistor de puissance.

Le transistor d'auto-polarisation et le transistor de puissance sont de préférence des transistors à effet de champ de type HEMT. Ils sont de préférence en technologie GaN ou AsGa.

Certaines connexions dans la cellule pourront être rendues résistives, par ajout de résistances, permettant des réglages fins de la structure de la cellule, dans le but d'améliorer son rendement en fonction des conditions d'utilisation opérationnelles.

L'invention concerne aussi un équipement électronique comprenant une pluralité de cellules de commutation de puissance en parallèle, reliées en commun à un même port de sortie.

D'autres caractéristiques et avantages de l'invention sont décrits dans la description détaillée suivante, faite à titre indicatif en référence aux dessins annexés, dans lesquels :

- la figure 1 déjà décrite illustre une structure de base d'une cellule de commutation de puissance de l'art antérieur utilisant une résistance d'auto-polarisation de grille du transistor de puissance;
- les trois figures 2, 3 et 4 montrent les courbes courant et tension drain source du transistor de puissance, obtenues par simulation d'une telle cellule, pour trois valeurs de la résistance d'auto-polarisation ;
- la figure 5 illustre une structure perfectionnée de cellule de commutation de puissance selon l'invention ;
- la figure 6 illustre des possibilités de stabilisation de la réponse de la cellule par ajouts de résistances supplémentaires dans la structure de la figure 2 ;
- la figure 7 montre les formes de la tension et du courant drain source du transistor de puissance obtenus par simulation d'une cellule selon l'invention ;
- la figure 8 montre les formes de la tension et du courant drain source du transistor de puissance obtenus par simulation d'une cellule suivant un perfectionnement de l'invention;
- les figures 9 et 10 montrent des courbes de tension et de courant en entrée d'une cellule selon l'invention, et
- les figures 11 et 12 montrent les courbes de tension $V_{out}(t)$ et de courant $I_{out}(t)$ correspondantes en sortie $P_{out}$ d'une cellule selon l'invention ;
- la figure 13 illustre une application de la cellule suivant l'invention à un équipement électronique utilisant plusieurs cellules de commutation de puissance en parallèle.

## DESCRIPTION DETAILLEE DE L'INVENTION

Une structure de base d'une cellule selon l'invention est illustrée sur la figure 5. Par simplicité, les éléments communs à la cellule de l'état de l'art illustrée par les figures 1 à 4 et à la cellule de l'invention illustrée par les figures 5 à 13 portent les mêmes références. Les transistors de puissance et d'auto-polarisation de la cellule sont des transistors à effet de champ, du type normalement conducteur (état ON), même si cela n'est pas nécessairement précisé pour ne pas alourdir l'exposé.

La structure de base d'une cellule selon l'invention illustrée sur la figure 5 a en commun avec la cellule de l'état de l'art illustrée à la figure 1, le commutateur de courant formé par le transistor d'entrée $T_1$ et le transistor de puissance $T_2$ qui commute la haute tension $V_{DD}$.

La résistance d'auto-polarisation $R_2$ de grille du transistor de puissance de la cellule de la figure 1 est remplacée dans la cellule selon l'invention par un circuit d'auto-polarisation de grille P qui comprend :

- un transistor $T_3$ qui est un transistor à effet de champ de type normalement conducteur, connecté comme suit : son drain $d_3$ est relié à la source $s_2$ du transistor de puissance $T_2$ et donc au plot de sortie Out de la cellule ; sa source $s_3$ est reliée à la grille $g_2$ ; sa grille $g_3$ est reliée à la résistance $R_3$ ; et
- une résistance d'auto-polarisation $R_3$ de la grille $g_3$ du transistor $T_3$, connectée entre cette grille $g_3$ et la source $s_3$ du transistor $T_3$, et en série avec le drain du premier transistor $T_1$.

La résistance $R_1$ sur le drain du transistor $T_1$, présente dans la cellule antérieure, n'est pas représentée ici. Elle est optionnelle.

L'ensemble formé par le circuit d'auto-polarisation P et le transistor de puissance $T_2$ constitue la charge du transistor d'entrée $T_1$, charge qui est ainsi placée en série entre le drain $d_1$ du transistor $T_1$ et la tension d'alimentation positive $V_{DD}$.

On notera que dans cette structure, le transistor $T_3$ est comme le transistor $T_2$, un transistor à source flottante, au sens que sa source $s_3$ n'est pas référencée à un potentiel fixe : elle suit la tension de grille du transistor de puissance $T_2$.

On notera aussi que si dans l'exemple le commutateur de courant est formé d'un transistor T1, il pourrait en comprendre plusieurs, par exemple pour former une paire différentielle.

Le fonctionnement d'une cellule selon l'invention va maintenant être expliqué, en considérant une charge purement résistive de sortie, notée $R_L$.

La cellule a deux états stables, les états ON et OFF :

- la cellule est dite à l'état ON lorsque les transistors $T_2$ et $T_3$ sont passants (état ON), et que la structure délivre de la puissance à la charge ;
- la cellule est dite à l'état OFF lorsque les transistors $T_2$ et $T_3$ sont à la limite du blocage (état OFF) et que la charge est isolée de l'alimentation principale

Les transistors $T_3$ et $T_2$ sont commandés à l'état On, passant ou OFF, bloqué, en fonction du signal de commande $V_{IN}$ appliqué en entrée In de la cellule, et qui commande l'état ON ou OFF du transistor $T_1$.

Comme détaillé plus loin, le transistor $T_1$ est un commutateur de courant. Il est activé pour commuter un courant vers la charge formée par le circuit d'auto-polarisation P et le transistor de puissance, et amener la cellule dans l'état OFF. Le courant commuté par $T_1$ est faible, en comparaison du courant commuté par le transistor principal. Ainsi, si le transistor $T_1$ peut-être choisi de même technologie et de même type que les transistors $T_2$ et $T_3$, c'est-à-dire des transistors à effet de champ en technologie HEMT de type normalement conducteurs, il pourrait être de technologie (par exemple MOS) ou de type de conduction différent. Dans la suite, et notamment dans les exemples de simulation qui sont expliqués, on a choisi les trois transistors de même technologie, HEMT, et de type normalement conducteur, permettant ainsi avantageusement la réalisation dudit circuit en puces monolithiques (MMICs) pour bénéficier de leurs avantages en termes d'intégration et de réduction des éléments parasites de câblage.

**Fonctionnement à l'état OFF**

Lorsque le transistor $T_1$ est à l'état ON (par exemple $V_{IN}$=Vss=0 volt), les transistors $T_2$ et $T_3$ s'auto-polarisent - considérant une cellule avec des éléments judicieusement choisis pour permettre son bon fonctionnement- de façon à être tous deux dans un état proche du pincement (limite de blocage).

Considérons un modèle idéal simple pour les transistors $T_2$ et $T_3$ de la forme : $Ids_i = Gm_i . (Vgs_i - Vp)$.

(où $Ids_i$, $Gm_i$, et $Vgs_i$ sont les notations usuelles pour désigner respectivement le courant drain-source, la transconductance et la tension grille-source d'un transistor $T_i$ (i = 1 ou 2). Vp est la tension de pincement, qui est identique pour les deux transistors, fonction de la technologie).

Alors on montre que la tension grille source du transistor $T_2$ à l'état OFF, notée $Vgs_{2\_OFF}$, est donnée par l'équation EQ1 suivante:

$$Vgs_{2\_OFF} = \left[ \frac{R_L.Gm_2 - 1 - Vss}{R_L.Gm_2 + 1} - \frac{Gm_3.(R_3 + R_L)}{(R_L.Gm_2 + 1).(R_3.Gm_3 + 1)} \right].Vp$$

Ceci montre que, la valeur de la tension grille-source de $T_2$ à son état quasi-pincé peut-être réglée à une valeur très proche de -Vp, par un choix judicieux des éléments et des valeurs des tensions, et en particulier par un choix approprié des valeurs de $R_3$ et de Vss. On peut ainsi limiter le courant de drain à l'état OFF du transistor $T_2$ à des valeurs très faibles.

En référençant la source de $T_1$ à la masse (Vss =0 volt), on peut montrer qu'avec un choix optimisé des éléments de la cellule, le courant de drain à l'état OFF du transistor $T_2$ est largement inférieur à celui obtenu dans le cas d'une cellule de l'art antérieur, présentée en introduction. Ainsi, le fait de remplacer seulement la résistance d'auto-polarisation $R_2$ de la cellule antérieure, par le circuit d'auto-polarisation proposé est déjà avantageux en soi.

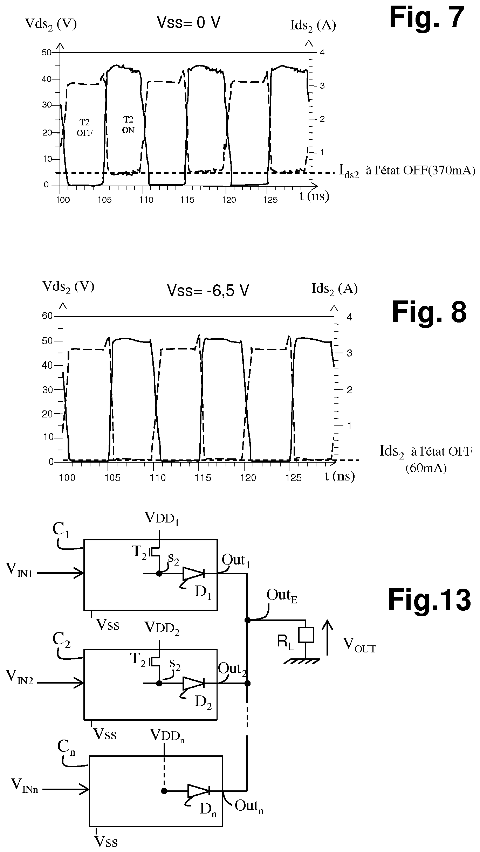

En référençant la source du transistor $T_1$ à une tension Vss plus négative (et non plus à la masse), par exemple à -6,5 volts, cela permet d'approcher davantage la tension grille-source à l'état OFF du transistor $T_2$ $Vgs_{2\_OFF}$, donc de réduire encore davantage le courant de drain à l'état OFF du transistor $T_2$, et donc d'améliorer encore davantage le rendement de la cellule. Cette solution est donc avantageuse, comme nous le montrerons plus loin en référence aux figures 8 à 12.

Comme indiqué précédemment, le transistor $T_1$ est un commutateur de courant. Le courant I commuté par le transistor $T_1$ contrôle le point de fonctionnement du transistor $T_3$ du circuit d'auto-polarisation P : ce courant I fixe en effet la tension grille-source $Vgs_3$, $Vgs_3=I.R_3$, et le courant drain source $Ids_3$, $Ids_3=I$, du transistor $T_3$. A ce point de fonctionnement correspond une valeur déterminée de tension drain source $Vds_3$ du transistor $T_3$. Par construction, la tension drain-source du transistor $T_3$ est égale à la tension grille-source $Vgs_2$ du transistor $T_2$. Ainsi, le transistor $T_1$ commuté à l'état ON, permet bien un contrôle en courant de la tension grille-source du transistor de commutation de puissance $T_2$ à l'état OFF ($Vgs_{2\_OFF}$).

Il s'agit d'un contrôle indirect, puisque le courant I, commuté par le transistor $T_1$ est en fait fourni par la structure de la cellule. Les valeurs du courant I et de la tension $Vgs_{2\_OFF}$ ne sont ainsi pas directement réglables. On les règle indirectement, par un dimensionnement approprié de la structure de la cellule, et notamment par un choix approprié des valeurs de la résistance $R_3$ et de la tension Vss, comme mis en évidence par l'équation EQ1.

On notera que l'on peut prévoir de connecter une source de courant (transistor, miroir de courant, ....), réglable, en série entre le commutateur de courant formé par le transistor $T_1$, et la masse Vss (cf Figure 5, source de courant SC représentée en pointillé). Le courant I fourni par la source de courant SC et commuté par le transistor $T_1$, est alors directement réglable à une valeur appropriée, qui permet d'obtenir une tension $Vgs_{2\_OFF}$ très proche de Vp, ce qui permet de limiter de façon optimale les pertes électriques de la cellule à l'état OFF.

## Fonctionnement à l'état ON

Lorsque le transistor $T_1$ est à l'état OFF (par exemple $V_{IN}=Vp+Vss$) (c'est-à-dire qu'il ne conduit plus de courant vers la charge formée du circuit d'auto-polarisation et le transistor de puissance), le transistor $T_3$ est commuté dans l'état passant On. Dans cet état, il est équivalent, en sa sortie, à une résistance $Rds_{3\_ON}$, connectée entre la grille ($g_2$) et la source ($s_2$) du transistor de puissance $T_2$, de très faible valeur. Le transistor $T_2$ lui aussi est à l'état passant On.

## Commutation OFF → ON

Pour que le transistor $T_2$ commute vite de l'état OFF à l'état ON, il faut qu'au moment où le transistor $T_2$ commence à commuter, l'impédance présentée à l'entrée de $T_2$ soit faible pour favoriser sa commutation rapide. En d'autres termes, le transistor $T_3$, en sa sortie, doit être équivalent à une résistance de faible valeur. C'est le cas quand le transistor $T_3$ est à l'état passant. Cependant, pendant la phase transitoire de commutation, $T_3$ lui aussi commute de l'état quasi-bloqué à l'état passant. Il présente alors à $T_2$ une résistance qui varie d'une valeur importante à une valeur faible. Cependant, dans la pratique, le transistor $T_3$ a un développement bien inférieur à $T_2$ car il n'a pas à conduire de courant fort. Sa capacité d'entrée $c_{in3}$ est donc beaucoup plus faible que la capacité d'entrée $c_{in2}$ de $T_2$ et ainsi il peut commuter très rapidement. Sa résistance équivalente de sortie équivaut donc très rapidement à sa résistance à l'état passant, faible, ce qui permet également à $T_2$ de commuter très rapidement.

Le temps de commutation du transistor $T_2$ de l'état OFF à l'état ON est donné par la formule : $t_{ON->OFF} = R_{eq(T3)}.c_{in2}$, où $R_{eq(T3)}$ désigne la résistance équivalente du transistor $T_3$ et c'est une valeur moyenne : lorsque $T_3$ est à l'état OFF, sa résistance équivalente est élevée. Quand $T_3$ commute à l'état On, sa résistance équivalente devient de plus en plus faible, jusqu'à une valeur qui va être très faible, et en pratique bien plus faible que la valeur optimale de la résistance $R_2$ qui est définie pour la structure de cellule de l'art antérieur (Figure 1).

Ainsi tous les effets concourent favorablement dans le même sens.

Notons que la cellule selon l'invention ne nécessite aucune circuiterie particulière de gestion de décalages temporels des commutations des différents transistors, chose qu'il serait malaisé de réaliser aux fréquences de commutation visées.

Notons aussi que l'appel de courant important généré par la charge rapide de la capacité d'entrée de $T_2$ transite entre le drain et la source de $T_3$ et donc le dimensionne : un transistor $T_3$ de trop petit développement ne pourrait pas délivrer suffisamment de courant et induirait un ralentissement de la commutation. Un transistor $T_3$ de développement trop important pourrait laisser passer le courant lors du transitoire, mais aurait une capacité d'entrée plus grande et commuterait donc plus lentement. En pratique, dans l'exemple de circuit proposé, le transistor $T_3$ a un développement total de grille huit fois inférieur au transistor $T_2$. Il est donc capable de conduire huit fois moins de courant, mais a une capacité d'entrée huit fois inférieure.

La cellule de l'invention offre donc un bien meilleur rendement et a beaucoup d'avantages.

Ceci apparaît sur les courbes des figures 7 à 12 obtenues par simulation en utilisant pour les éléments en commun, les mêmes données de simulation que la cellule de l'art antérieur illustrée à la figure 1. Notamment le signal $V_{IN}$ a un rapport cyclique de 50% à une fréquence de découpage de 100 MHz. La tension de pincement $V_p$ des transistors est de l'ordre de -3,5 volts. Le transistor $T_3$ est choisi identique au transistor $T_1$, et la résistance $R_3$ vaut 35 Ohms.

Ces simulations ont été faites pour le cas où Vss est choisie nulle (Figure 7), ou négative (Figures 8 à 12).

Les courbes de tension $V_{ds2}$ et courant drain-source $I_{ds2}$ du transistor $T_2$ des figures 7 et 8 illustrent respectivement le cas où la tension de référence Vss est nulle et le cas où elle est négative.

**Cas où Vss=0V**

La figure 7 illustre la simulation de la cellule lorsque la tension Vss correspond au potentiel de référence de masse électrique (0 volt).

Elle montre que l'on obtient un courant drain-source à l'état OFF du transistor $T_2$ de l'ordre de 370 milliampères et un temps de commutation $t_{ON->OFF}$ qui est inférieur à 1 nanoseconde. La tension drain-source $V_{ds2}$ à l'état OFF est de l'ordre de 45 volts. Le rendement total calculé pour cette cellule dans les conditions de simulation est ainsi de 84%.

Lorsque la cellule est à l'état OFF, on ne retrouve pas zéro volt en sortie Out de la cellule mais une tension non nulle, du fait que $T_2$ n'est pas totalement pincé (il est en limite de blocage).

**Cas où Vss est négatif**

La figure 8 illustre le cas où la source $s_1$ du transistor d'entrée est polarisée à un potentiel Vss plus négatif que la masse électrique, dans l'exemple à -6,5 volts. Comme illustrée sur la figure 2, la tension $V_{DD}$ commutée en sortie est définie par rapport à une masse de potentiel de référence nul, $G_{ND}$. Le signal d'entrée $V_{IN}$ est défini par rapport au potentiel de référence Vss, de manière à commander de manière appropriée l'état ON, respectivement OFF du transistor $T_1$.

Dans l'exemple il varie entre -5,5 volts (niveau haut) et -10 volts (niveau bas). La tension grille-source du transistor $T_1$ varie ainsi entre +1 V, commandant un état ON et -3,5 Volts, commandant un état OFF.

En fixant Vss à un potentiel plus négatif, de préférence voisin de 2Vp (dans l'exemple on a Vp de l'ordre de -3,5 volts), lorsque la cellule est à l'état OFF, Vss contribue alors à améliorer le pincement de $T_2$ à l'état OFF, comme cela ressort de l'équation EQ1 de $Vgs_{2\_OFF}$ indiquée supra. Les pertes électriques à l'état OFF de la cellule en sont encore réduites ; et le rendement total de la cellule est donc amélioré.

C'est bien ce que montre la figure 8 : le courant $Ids_2$ à l'état OFF est encore plus faible que dans les conditions à Vss nulle de la figure 7 : il passe de 370 milliampères à 60 milliampères environ. On obtient un rendement de la cellule égal à 90%, avec une puissance de sortie de 72 watts à la fréquence de découpage de 100 Mégahertz, ce qui est une bonne performance et une franche amélioration par rapport au rendement de 77% au mieux obtenue avec la cellule de l'art antérieur (figure 1) pour une puissance de sortie comparable (75 watts).

En pratique, la fixation de la tension Vss de polarisation de la source du transistor $T_1$ à une tension nulle, ou une tension plus négative, souvent proche de 2.Vp, peut dépendre des performances attendues pour une application donnée, et/ou des possibilités pratiques de disposer d'une référence de tension négative.

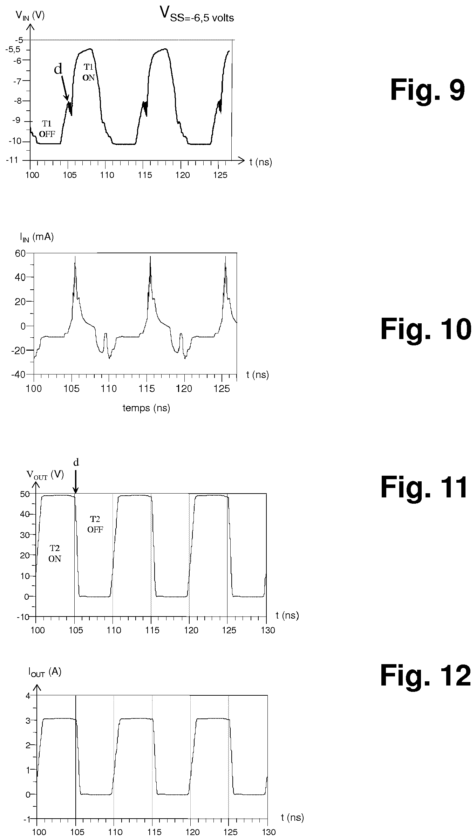

Les figures 9 à 12 montrent les formes des tensions et courants d'entrée et de sortie de la cellule selon l'invention de la figure 5, obtenues dans les mêmes conditions de simulation de la cellule de l'art antérieur, mais en prenant une tension de référence Vss égale -6,5 volts.

Elles mettent en évidence différents aspects favorables de fonctionnement de la cellule selon l'invention, notamment :

-   l'obtention d'une tension de sortie $V_{OUT}$ en créneaux dont la largeur et la répétition sont contrôlées par la tension d'entrée $V_{IN}$ avec des fronts de commutation plus rapides que ceux de la tension d'entrée, permettant un relâchement sur les contraintes de génération ou mise en forme du signal d'entrée ;
-   le changement d'état de la cellule qui est obtenu pour une variation très faible, de l'ordre de quelques millivolts, de la tension d'entrée $V_{IN}$ au voisinage d'un seuil de déclenchement ; on peut ainsi commuter de fortes puissances, dans l'exemple plusieurs dizaines de watts, à haute fréquence avec un minimum d'énergie de commande, quelques milliwatts en pratique.

La figure 9 illustre la courbe de tension d'entrée $V_{IN}$ du signal d'entrée appliqué sur la grille $g_1$ du transistor $T_1$. La tension d'entrée $V_{IN}$ varie entre un niveau bas de -10 volts et un niveau haut de - 5,5 volts pour faire commuter le transistor $T_1$ entre les états OFF et On, avec un temps de variation entre ces deux niveaux de l'ordre de 3 à 4 nanosecondes. La tension $Vgs_1$ du transistor $T_1$ varie ainsi entre -3,5 volts et +1 volt.

La figure 10 montre la courbe de courant d'entrée $I_{IN}$ dans la capacité d'entrée du transistor $T_1$. Elle met en évidence l'appel de courant dans la capacité d'entrée du transistor $T_1$ quand il commence à commuter de l'état OFF à l'état ON, à l'instant marqué par le repère d sur la figure 9, entraînant le changement d'état de la cellule de ON à OFF.

La figure 11 représente la tension $V_{OUT}$ au noeud de sortie de la cellule. En d'autres termes, c'est la tension relevée sur la source $s_2$ du transistor de puissance $T_2$ : Elle a une forme en créneaux, variant entre un niveau proche de $V_{DD}$, quand le transistor de puissance $T_2$ est à l'état ON (équivalent à un court-circuit) ; et proche de zéro volt quand le transistor de puissance $T_2$ est à l'état OFF. Les fronts de commutation sont rapides, de l'ordre de 1 à 2 nanosecondes, voire inférieurs à la nanoseconde : les variations du signal en sortie sont plus rapides que celles du signal d'entrée $V_{IN}$.

La figure 12 montre le courant de sortie $I_{OUT}$ appelé dans la charge (pour rappel, la charge est purement résistive dans l'exemple de la simulation) ; ce courant a une forme en créneaux qui suit la tension de sortie.

Ainsi, la cellule selon l'invention est plus performante et présente de nombreux avantages par rapport à la cellule selon l'art antérieur.

Son fonctionnement peut encore être ajusté, par ajout de résistances sur certaines connexions de la cellule, dans le but de rendre ces connexions plus résistives. Ces résistances, optionnelles, permettent en pratique de réaliser des réglages fins, dans le but d'améliorer le rendement de la cellule en fonction des conditions d'utilisation opérationnelles. Il s'agit principalement, par ces résistances, d'améliorer la marge de stabilité des transistors et de limiter des effets de surtensions ou de rebonds induits par des selfs parasites de la structure, néfastes au rendement.

La figure 6 montre ainsi différentes résistances qui pourront être prévues dans la structure de cellule selon l'invention. En particulier :

- la connexion entre la grille $g_2$ du transistor de puissance $T_2$ et la résistance d'auto-polarisation $R_3$ peut comprendre une résistance $r_1$ ;
- la connexion entre la résistance d'auto-polarisation $R_3$ et la source $s_3$ du transistor $T_3$ peut comprendre une résistance $r_2$ ;
- la connexion entre le drain $d_3$ du deuxième transistor $T_3$ et la source $s_2$ du transistor de puissance $T_2$ peut comprendre une résistance $r_3$;
- la connexion entre la résistance d'auto-polarisation $R_3$ et la grille $g_3$ du deuxième transistor $T_3$ peut comprendre une résistance $r_4$ connectée entre cette grille $g_3$ et la résistance $R_3$ ;
- la connexion entre le port d'entrée In et la grille $g_1$ du transistor d'entrée $T_1$ ($g_1$ entrée de commande du commutateur de courant $T_1$) peut comprendre une résistance $r_5$.
- la connexion entre le drain $d_1$ du transistor d'entrée $T_1$ et la résistance $R_3$ peut comprendre une résistance $r_6$.

La valeur de chacune de ces résistances $r_1$ à $r_6$ est en pratique déterminée par simulation des conditions opérationnelles, pour une application donnée. Selon les cas, à l'issue de la simulation, zéro, une, plusieurs ou toutes ces résistances seront déterminées avec une valeur non nulle.

La cellule de commutation qui vient d'être décrite peut être utilisée seule, ou avec d'autres cellules de même type. La figure 13 illustre ainsi le cas d'un équipement électronique dans lequel plusieurs cellules selon l'invention sont utilisées en parallèle, avec leurs ports de sortie tous reliés à un port de sortie commun. Chaque cellule comprend alors en outre une diode de protection en sortie.

Dans l'exemple illustré, un équipement électronique comprend ainsi n cellules en parallèles, $C_1$, $C_2$,... $C_n$. Chaque cellule $C_i$ est commandée par un signal de commande $V_{IN_i}$ qui lui est propre pour commuter une tension différente $V_{DD_i}$, où l'indice i égal 1,...n.

Les n cellules sont connectées en sortie à un même noeud de sortie $Out_E$ qui est relié à une charge matérialisée ici par une résistance $R_L$. La diode de protection $D_i$ de chaque cellule $C_i$ est connectée entre un noeud de sortie $Out_i$ de la cellule (correspondant à la source $s_2$ du transistor de puissance $T_2$ de la cellule) et le noeud de sortie de l'équipement, $Out_E$.

Dans un tel montage, si une seule cellule parmi les n cellules est à l'état ON, par exemple $C_2$, et toutes les autres cellules sont à l'état OFF, c'est la tension $V_{DD_2}$ commutée par la cellule à l'état ON que l'on retrouve sur le noeud de sortie $Out_E$ : $Vout_E = V_{DD_2}$.

Toutes les autres cellules étant à l'état OFF, la tension sur le noeud de sortie de ces cellules est nulle ou presque (proche de -Vp) : la diode de protection de chacune de ces cellules "OFF" est donc bloquée en inverse, voyant chacune une tension négative sensiblement égale à $-V_{DD_2}$ à leurs bornes.

Si maintenant deux cellules (ou plus) sont passantes, par exemple les cellules $C_2$ et $C_n$, avec $V_{DD_2} > V_{DD_n}$, alors en sortie c'est encore la tension la plus élevée, $V_{DD_2}$ dans l'exemple, que l'on retrouve en sortie, et la diode de protection $D_n$ de la cellule $C_n$ est bloquée en inverse (sa tension est $V_{DD_n} - V_{DD_2} < 0$).

Cet exemple illustre que si la cellule associée à la plus petite tension à commuter, dans l'exemple $V_{DD_n}$, est à l'état ON, la tension au noeud de sortie de l'équipement sera égale à $V_{DD_n}$ seulement si aucune autre cellule n'est à l'état ON.

Dans une variante, ont peut prévoir que cette cellule $C_n$ qui reçoit la tension d'alimentation positive à commuter $V_{DDn}$ la plus petite peut être formée par la seule diode de protection. Cette diode de protection sera alors reliée directement entre la tension d'alimentation positive à commuter et la sortie de la cellule.

La cellule $C_n$ peut se résumer à la diode de protection $D_n$ qui sera alors reliée directement entre la tension $V_{DDn}$ et le noeud de sortie de l'équipement. La diode $D_n$ ne sera alors passante que si toutes les autres cellules $C_1$ à $C_{n-1}$ sont à l'état OFF.

Les cellules étant capables de commuter des tensions élevées, ce montage à n cellules (ou sa variante) permet par exemple de réaliser, avec une logique simple, un convertisseur de puissance numérique analogique comme décrit en détails dans la demande précitée WO2012/072503.

L'invention qui vient d'être décrite propose ainsi une cellule de commutation de puissance à commande non-isolée particulièrement performante avec une structure qui reste peu encombrante et peu coûteuse : il n'y a pas de circuiterie complexe de mise en forme de signaux, ni de gestion de décalage de temps de commutation ; le transistor $T_3$ ajouté n'est pas un transistor ayant à commuter de la puissance ; la commutation du transistor $T_3$ utilisé en résistance variable du transistor de puissance et du transistor de puissance $T_2$, est assurée à partir d'un commutateur de courant commandé par le signal d'entrée de la cellule. Ce commutateur peut être un transistor, comme illustré et peut-être associé à une source de courant réglable.

Cette cellule peut être utilisée seule ou en nombre dans de multiples applications de commutation de puissance haute fréquence, mais aussi et a fortiori pour des applications plus basses fréquences.

## Revendications

1. Cellule de commutation de puissance comprenant,

   - un port d'entrée (In) apte à recevoir un signal de commande ($V_{IN}$) de commutation qui est référencé à une masse générale (Gnd) de la cellule, constituant une commande non-isolée de la cellule,
   - un transistor de puissance à effet de champ ($T_2$), de type normalement conducteur, dont le drain ($d_2$) est apte à recevoir une tension d'alimentation positive ($V_{DD}$), définie par rapport à une masse à potentiel de référence nul, pour l'appliquer sur un port de sortie (Out), la source ($s_2$) du transistor de puissance étant connectée au port de sortie (Out),
   - un circuit d'auto-polarisation (P) de la grille ($g_2$) du transistor de puissance, et
   - un commutateur de courant ($T_1$) connecté électriquement entre le circuit d'auto-polarisation et un potentiel de référence négatif ou nul (Vss) dont une entrée de commande de commutation ($g_1$) est connectée au port d'entrée, et configuré pour que, sur activation par ledit signal de commande de commutation ($V_{IN}$), il relie électriquement le potentiel de référence négatif ou nul au circuit d'auto-polarisation,
   ce circuit d'auto-polarisation comprend
   - un transistor à effet de champ ($T_3$), de type normalement conducteur, dont le drain ($d_3$) est connecté à la source ($s_2$) du transistor de puissance ($T_2$) et dont la source ($s_3$) est connectée à la grille ($g_2$) du transistor de puissance ;
   - une résistance d'auto-polarisation ($R_3$) de la grille ($g_3$) du transistor du circuit d'auto-polarisation($T_3$), qui est connectée entre la grille ($g_3$) et la source ($s_3$) dudit transistor d'auto-polarisation ($T_3$); et en série entre le commutateur de courant ($T_1$) et la source ($s_3$) dudit transistor d'auto-polarisation($T_3$).

2. Cellule de commutation selon la revendication 1, comprenant une source de courant réglable (SC) connectée en série entre ledit commutateur de courant et la référence de tension négative ou nulle (Vss).

3. Cellule de commutation selon la revendication 1 ou 2, dans laquelle le commutateur de courant comprend au moins un transistor à effet de champ (T1) électriquement connecté entre le circuit d'auto-polarisation (P) et le potentiel de référence négatif ou nul (Vss).

4. Cellule de commutation selon la revendication 3, dans laquelle le commutateur de courant est à transistor(s) à effet de champ de type normalement conducteur.

5. Cellule de commutation selon l'une des revendications 1 à 4 dans laquelle l'activation du commutateur de courant ($T_1$) par le signal d'entrée ($V_{IN}$), commande la commutation à l'état OFF, dans un état à la limite du blocage, du transistor d'auto-polarisation ($T_3$) et du transistor de puissance et la désactivation du commutateur de courant ($T_1$), commande la commutation à l'état ON desdits transistor d'auto-polarisation et transistor de puissance.

**6.** Cellule de commutation selon l'une quelconque des revendications 1 à 5, dans laquelle au moins une des connexions dans la liste suivante comprend une résistance supplémentaire ($r_1$, $r_2$, $r_3$, $r_4$, $r_5$, $r_6$) : la connexion entre la grille ($g_2$) du transistor de puissance ($T_2$) et la résistance d'auto-polarisation ($R_3$) ; la connexion entre le drain ($d_3$) du transistor d'auto-polarisation ($T_3$) et la source ($s_2$) du transistor de puissance ($T_2$) ; la connexion entre la grille ($g_3$) du transistor d'auto-polarisation ($T_3$) et la résistance d'auto-polarisation ($R_3$) ; la connexion entre la résistance d'auto-polarisation ($R_3$) et la source ($s_3$) du transistor d'auto-polarisation ($T_3$) ; la connexion entre l'entrée de commande ($g_1$) du commutateur de courant ($T_1$) et le port d'entrée (In) est résistive ; la connexion entre le commutateur de courant ($T_1$) et la résistance d'auto-polarisation ($R_3$).

**7.** Cellule de commutation selon l'une quelconque des revendications 1 à 6, dans laquelle le transistor d'auto-polarisation ($T_3$) et le transistor de puissance ($T_2$) sont des transistors à effet de champ de type HEMT.

**8.** Cellule de commutation selon la revendication 6, dans laquelle les transistors à effet de champ de type HEMT sont réalisés dans une technologie choisie dans la liste suivante : GaN, GaAs.

**9.** Equipement électronique comprenant n cellules de commutation de puissance ($C_1$, $C_2$, ...$C_n$) ou (C1.....Cn-1) selon l'une quelconque des revendications 1 à 8, les n cellules étant disposées en parallèle, n entier supérieur à 1, avec leurs ports de sortie ($Out_1$, $Out_2$, ...$Out_n$) reliés à un port de sortie commun ($Out_E$) de l'équipement, **caractérisé en ce que** chaque cellule ($C_1$) comprend une diode d'isolation ($D_1$) disposée en série entre la source ($s_2$) du transistor de commutation de puissance ($T_2$) de la cellule et le port de sortie commun ($Out_E$).

**10.** Equipement électronique selon la revendication 9, dans lequel chaque cellule reçoit une tension d'alimentation positive respective ($V_{DD_1}$, $V_{DD_2}$, ...$V_{DD_n}$) en sortie, **caractérisé en ce que** celle ($C_n$) des cellules qui reçoit la tension d'alimentation positive la plus petite est formée par la seule diode de protection ($D_n$) qui est reliée directement entre la tension d'alimentation positive à commuter ($V_{DD_n}$) et la sortie $O_{utn}$ de la cellule.

**Patentansprüche**

**1.** Leistungsschaltzelle, die Folgendes umfasst:

- einen Eingangsport (In), der ein Schaltsteuersignal ($V_{IN}$) empfangen kann, das auf eine allgemeine Masse (Gnd) der Zelle referenziert ist, zum Bilden einer nicht isolierten Steuerung der Zelle;
- einen normal leitenden Feldeffektleistungstransistor ($T_2$), dessen Drain ($d_2$) eine relativ zu einer Masse mit Null-Referenzpotenzial definierte positive Speisespannung ($V_{DD}$) empfangen kann, um sie an einen Ausgangsport (Out) anzulegen, wobei die Source ($s_2$) des Leistungstransistors mit dem Ausgangsport (Out) verbunden ist;
- eine Selbstpolarisationsschaltung (P) des Gate ($g_2$) des Leistungstransistors; und
- einen Stromschalter ($T_1$), der elektrisch zwischen der Selbstpolarisationsschaltung und einem negativen oder Null-Referenzpotenzial (Vss) geschaltet ist, von dem ein Schaltsteuereingang ($g_1$) mit dem Eingangsport verbunden ist, und so konfiguriert, dass er nach dem Aktivieren durch das Schaltsteuersignal ($V_{IN}$) das negative oder Null-Referenzpotenzial mit der Selbstpolarisationsschaltung verbindet,

wobei die Selbstpolarisationsschaltung Folgendes umfasst:

- einen normal leitenden Feldeffekttransistor ($T_3$), dessen Drain ($d_3$) mit der Source ($s_2$) des Leistungstransistors ($T_2$) verbunden ist und dessen Source ($s_3$) mit dem Gate ($g_2$) des Leistungstransistors verbunden ist;
- einen Selbstpolarisationswiderstand ($R_3$) des Gate ($g_3$) des Transistors der Selbstpolarisationsschaltung ($T_3$), der zwischen dem Gate ($g_3$) und der Source ($s_3$) des Selbstpolarisationstransistors ($T_3$) geschaltet und in Serie zwischen dem Stromschalter ($T_1$) und der Source ($s_3$) des Selbstpolarisationstransistors ($T_3$) geschaltet ist.

**2.** Schaltzelle nach Anspruch 1, die eine regelbare Stromquelle (SC) umfasst, die in Serie zwischen dem Stromschalter und der negativen oder Null-Referenzspannung (Vss) geschaltet ist.

**3.** Schaltzelle nach Anspruch 1 oder 2, wobei der Stromschalter wenigstens einen Feldeffekttransistor ($T_1$) umfasst, der elektrisch zwischen der Selbstpolarisationsschaltung (P) und dem negativen oder Null-Referenzpotenzial (Vss) geschaltet ist.

**4.** Schaltzelle nach Anspruch 3, wobei der Stromschalter einen oder mehrere normal leitende Feldeffekttransistoren hat.

**5.** Schaltzelle nach einem der Ansprüche 1 bis 4, wobei die Aktivierung des Stromschalters ($T_1$) durch das Eingangssignal ($V_{IN}$) das Schalten des Selbstpolarisationstransistors ($T_3$) und des Leistungstransistors in den Ausschaltzustand, in einem Zustand an der Sperrgrenze, steuert, und das Deaktivieren des Stromschalters ($T_1$) das Schalten des Selbstpolarisationstransistors und des Leistungstransistors in den Einschaltzustand steuert.

**6.** Schaltzelle nach einem der Ansprüche 1 bis 5, wobei wenigstens eine der Verbindungen in der folgenden Liste einen zusätzlichen Widerstand ($r_1$, $r_2$, $r_3$, $r_4$, $r_5$, $r_6$) umfasst: die Verbindung zwischen dem Gate ($g_2$) des Leistungstransistors ($T_2$) und dem Selbstpolarisationswiderstand ($R_3$); die Verbindung zwischen dem Drain ($d_3$) des Selbstpolarisationstransistors ($T_3$) und der Source ($s_2$) des Leistungstransistors ($T_2$); die Verbindung zwischen dem Gate ($g_3$) des Selbstpolarisationstransistors ($T_3$) und dem Selbstpolarisationswiderstand ($R_3$); die Verbindung zwischen dem Selbstpolarisationswiderstand ($R_3$) und der Source ($s_3$) des Selbstpolarisationstransistors ($T_3$); die Verbindung zwischen dem Steuereingang ($g_1$) des Stromschalters ($T_1$) und dem Eingangsport (In) ist resistiv; die Verbindung zwischen dem Stromschalter ($T_1$) und dem Selbstpolarisationswiderstand ($R_3$).

**7.** Schaltzelle nach einem der Ansprüche 1 bis 6, wobei der Selbstpolarisationstransistor ($T_3$) und der Leistungstransistor ($T_2$) HEMT-Feldeffekttransistoren sind.

**8.** Schaltzelle nach Anspruch 6, wobei die HEMT-Feldeffekttransistoren in einer Technologie produziert werden, die aus der folgenden Liste ausgewählt ist: GaN, GaAs.

**9.** Elektronisches Gerät, das n Leistungsschaltzellen ($C_1$, $C_2$, ...$C_n$) oder (C1.....Cn-1) nach einem der Ansprüche 1 bis 8 umfasst, wobei die n Zellen parallel angeordnet sind, wobei n eine ganze Zahl größer als 1 ist, deren Ausgangsports ($Out_1$, $Out_2$, ...$Out_n$) mit einem gemeinsamen Ausgangsport ($Out_E$) des Geräts verbunden sind, **dadurch gekennzeichnet, dass** jede Zelle ($C_1$) eine Isolationsdiode ($D_1$) umfasst, die in Serie zwischen der Source ($s_2$) des Leistungsschalttransistors ($T_2$) der Zelle und dem gemeinsamen Ausgangsport ($Out_E$) angeordnet ist.

**10.** Elektronisches Gerät nach Anspruch 9, wobei jede Zelle eine jeweilige positive Speisespannung ($V_{DD_1}$, $V_{DD_2}$, ...$V_{DD_n}$) am Ausgang erhält, **dadurch gekennzeichnet, dass** die Zelle ($C_n$) der Zellen, die die niedrigste positive Speisespannung erhält, von der einzigen Schutzdiode ($D_n$) gebildet wird, die direkt zwischen der zu schaltenden positiven Speisespannung ($V_{DD_n}$) und dem Ausgang $O_{utn}$ der Zelle geschaltet ist.

**Claims**

**1.** A power switching cell comprising:

- an input port (In) capable of receiving a switching control signal ($V_{IN}$), which is referenced to a general ground (Gnd) of the cell, forming a non-isolated control of the cell;
- a normally-on field effect power transistor ($T_2$), the drain ($d_2$) of which is capable of receiving a positive supply voltage ($V_{DD}$), which is defined relative to a ground at zero reference potential, in order to apply said voltage to an output port (Out), the source ($s_2$) of the power transistor being connected to the output port (Out);
- a self-biasing circuit (P) of the gate ($g_2$) of the power transistor; and
- a current switch ($T_1$) electrically connected between the self-biasing circuit and a negative or zero reference potential (Vss), one switching control input ($g_1$) of which is connected to the input port and which is configured so that, upon activation by said switching control signal ($V_{IN}$), it electrically connects the negative or zero reference potential to the self-biasing circuit,

said self-biasing circuit comprising:

- a normally-on field-effect transistor ($T_3$), the drain ($d_3$) of which is connected to the source ($s_2$) of the power transistor ($T_2$) and the source ($s_3$) of which is connected to the gate ($g_2$) of the power transistor;
- a self-biasing resistor ($R_3$) of the gate ($g_3$) of the transistor of the self-biasing circuit ($T_3$), which resistor is connected between the gate ($g_3$) and the source ($s_3$) of said self-biasing transistor ($T_3$) and is in series between the current switch ($T_1$) and the source ($s_3$) of said self-biasing transistor ($T_3$).

**2.** The switching cell according to claim 1, comprising an adjustable current source (SC) connected in series between said current switch and the negative or zero reference voltage (Vss).

3. The switching cell according to claim 1 or 2, wherein the current switch comprises at least one field-effect transistor ($T_1$) electrically connected between the self-biasing circuit (P) and the negative or zero reference potential (Vss).

4. The switching cell according to claim 3, wherein the current switch is one or more normally-on field-effect transistor(s).

5. The switching cell according to any one of claims 1 to 4, wherein the activation of the current switch ($T_1$) by the input signal ($V_{IN}$) controls switching to the OFF state, in a state at the locking limit, of the self-biasing transistor ($T_3$) and of the power transistor and the deactivation of the current switch ($T_1$) controls switching to the ON state of said self-biasing transistor and of said power transistor.

6. The switching cell according to any one of claims 1 to 5, wherein at least one of the connections from the following list comprises an additional resistor ($r_1$, $r_2$, $r_3$, $r_4$, $r_5$, $r_6$): the connection between the gate ($g_2$) of the power transistor ($T_2$) and the self-biasing resistor ($R_3$); the connection between the drain ($d_3$) of the self-biasing transistor ($T_3$) and the source ($s_2$) of the power transistor ($T_2$); the connection between the gate ($g_3$) of the self-biasing transistor ($T_3$) and the self-biasing resistor ($R_3$); the connection between the self-biasing resistor ($R_3$) and the source ($s_3$) of the self-biasing transistor ($T_3$); the connection between the control input ($g_1$) of the current switch ($T_1$) and the input port (In), which connection is resistive; the connection between the current switch ($T_1$) and the self-biasing resistor ($R_3$).

7. The switching cell according to any one of claims 1 to 6, wherein the self-biasing transistor ($T_3$) and the power transistor ($T_2$) are HEMT field-effect transistors.

8. The switching cell according to claim 6, wherein the HEMT field-effect transistors are produced using technology selected from the following list: GaN, GaAs.

9. An item of electronic equipment comprising n power switching cells ($C_1$, $C_2$, ...$C_n$) or (C1.....Cn-1) according to any one of claims 1 to 8, the n cells being arranged in parallel, with n being an integer that is greater than 1, with their output ports (Out$_1$, Out$_2$, ...Out$_n$) being connected to a shared output port (Out$_E$) of the equipment, **characterised in that** each cell ($C_1$) comprises an isolating diode ($D_1$) arranged in series between the source ($s_2$) of the power switching transistor ($T_2$) of the cell and the shared output port (Out$_E$).

10. The item of electronic equipment according to claim 9, wherein each cell receives a respective positive supply voltage ($V_{DD_1}$, $V_{DD_2}$, ...$V_{DD_n}$) at the output, **characterised in that** the cell ($C_n$) that receives the lowest positive supply voltage is formed by the single protection diode ($D_n$) that is directly connected between the positive supply voltage to be switched ($V_{DD_n}$) and the output $O_{utn}$ of the cell.

**Fig. 1**

ART ANTERIEUR

**Fig. 5**

**Fig. 6**

ART ANTERIEUR

R2<R$_{2\text{-opt}}$

Vds$_2$ (V)    Ids$_2$(A)

t$_{(ON \rightarrow OFF)}$<1ns

Ids$_2$ à l'état Off (1,13A)

t (ns)

# Fig. 2

# Fig. 3

R2>>R2-opt

Vds$_2$ (V)    Ids$_2$(A)

t$_{(ON \rightarrow OFF)}$ ~10 ns

Ids$_2$ à l'état OFF (100mA)

# Fig. 4

R2=R2-opt

Vds$_2$ (V)    Ids$_2$(A)

t$_{(ON \rightarrow OFF)}$ ~1 ns

Ids$_2$ à l'état OFF(800mA)

t (ns)

## Fig. 7

Vds$_2$ (V)      Vss= 0 V      Ids$_2$ (A)

I$_{ds2}$  à l'état OFF(370mA)

## Fig. 8

Vds$_2$ (V)      Vss= -6,5 V      Ids$_2$ (A)

Ids$_2$  à l'état OFF
(60mA)

## Fig.13

Fig. 9

Fig. 10

Fig. 11

Fig. 12

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5514996 A
- JP S62296617 A
- WO 2012072503 A1
- WO 2012072503 A